# EUROPEAN PATENT APPLICATION

(11) **EP 4 822 699 A1**
(43) Date of publication of application: **14.10.2026**
(21) Application number: 25227369.3
(22) Date of filing: 29.12.2025
(51) Int. Cl.: G11C 29/00, G11C 8/12, G11C 8/14

(54) **MEMORY DEVICE AND MEMORY SYSTEM**

(30) Priority: 07.04.2025 KR 20250044516
(71) Applicant: SK hynix Inc., Bubal-eub Icheon-si Gyeonggi-do 17336 (KR)
(72) Inventor: JANG, Mun Seon, 17336 Icheon-si, Gyeonggi-do (KR); KANG, Seong Yoon, 17336 Icheon-si, Gyeonggi-do (KR); JANG, Woong Ju, 17336 Icheon-si, Gyeonggi-do (KR); CHA, Sang Uhn, 17336 Icheon-si, Gyeonggi-do (KR)
(74) Representative: Isarpatent

(57) **Abstract**

A memory device includes a memory cell array including a plurality of cell groups, each cell group including adjacent ones of a plurality of cell blocks and alternately sharing sub-word line drivers with adjacent cell groups; a mapping control circuit configured to generate a mapping control signal according to an output option signal, while selectively inverting at least one bit of the mapping control signal based on a row address and a repair control signal including information on a repaired cell group among the plurality of cell groups; and a mapping circuit configured to select one of two adjacent cell groups based on respective bits of the mapping control signal, and to map selected cell groups to a plurality of data pads.

## Description

### BACKGROUND

### 1. Field

Various embodiments of the present disclosure relate to a semiconductor design technology, and more particularly, to a memory system including a memory device including an ECC engine.

### 2. Description of the Related Art

In the early days of the semiconductor memory industry, original good dies were formed mostly with no defective memory cells, in each memory chip that passed a semiconductor fabrication process on the wafer. However, as the capacity of memory devices gradually increases, it becomes difficult to make a memory device completely free of defective memory cells, and at present, it may be said that there is likely negligible possibility of fabrication of a memory device without defective memory cells. As one solution to overcome this situation, a method of repairing defective memory cells of a memory device with redundant memory cells or a method of correcting an error in data of memory cells using an error correction code (ECC) engine is being used.

Currently, various methods are being discussed to manage the maximum number of error bits that may occur in a memory device within an error correction capability of a memory controller.

### SUMMARY

Embodiments of the present disclosure are directed to a memory device and a memory system capable of changing a mapping between data pads and cell blocks sharing a sub-word line driver, to thereby limit the maximum number of error bits within the error correction capability of a memory controller.

In accordance with an embodiment of the present disclosure, a memory device includes: a memory cell array including a plurality of cell groups, each cell group including adjacent ones of a plurality of cell blocks and alternately sharing sub-word line drivers with adjacent cell groups; a mapping control circuit configured to generate a mapping control signal according to an output option signal, while selectively inverting at least one bit of the mapping control signal based on a row address and a repair control signal including information on a repaired cell group among the plurality of cell groups; and a mapping circuit configured to select one of two adjacent cell groups based on respective bits of the mapping control signal, and to map selected cell groups to a plurality of data pads.

In accordance with another embodiment of the present disclosure, a memory device includes: a memory cell array including a plurality of normal cell blocks, a redundancy cell block, and an error correction code (ECC) cell block, wherein adjacent ones of the plurality of normal cell blocks are grouped to form a plurality of normal cell groups, the redundancy cell block and the ECC cell block are grouped to form an extra cell group, and each cell group alternately shares sub-word line drivers with adjacent cell groups; a mapping circuit including a plurality of mappers respectively corresponding to a pair of normal cell groups among the plurality of normal cell groups, each mapper configured to select one of the pair of normal cell groups based on respective bits of a mapping control signal; and a mapping control circuit configured to identify target cell groups among the plurality of normal cell groups according to an output option signal, and detect that a repaired cell group is included in the target cell groups and that a cell group sharing the sub-word line drivers with the extra cell group is included in the target cell groups to set a bit of the mapping control signal to have a different value.

The pair of normal cell groups may include an odd-numbered normal cell group and an even-numbered normal cell group, which are arranged adjacent to each other. The mapping control circuit may be configured to, when a) the even-numbered normal cell groups are identified according to the output option signal, and b) the repaired cell group and the cell group sharing the sub-word line drivers with the extra cell group are included in the even-numbered normal cell groups: control a mapper corresponding to the repaired cell group, among the plurality of mappers, to select the odd-numbered normal cell group; and control remaining mappers among the plurality of mappers to select the even-numbered normal cell groups. The mapping control circuit may be configured to, when a) the odd-numbered normal cell groups are identified according to the output option signal, and b) the repaired cell group and the cell group sharing the sub-word line drivers are included in the odd-numbered normal cell groups: control a mapper corresponding to the repaired cell group, among the plurality of mappers, to select the even-numbered normal cell group; and control the remaining mappers among the plurality of mappers to select the odd-numbered normal cell groups. The memory device may further comprise a column control circuit configured to replace a defective column included in the plurality of normal cell blocks with a redundancy column of the redundancy cell block based on a repair control signal; and an ECC engine configured to correct an error in data output from the plurality of normal cell blocks based on an error correction code output from the ECC cell block, wherein the mapping circuit is disposed between the ECC engine and a plurality of data pads.

In accordance with yet another embodiment of the present disclosure, a memory system includes at least one memory device; and a memory controller configured to control operations of the at least one memory device, wherein the at least one memory device comprises: a memory cell array including a plurality of cell groups, each cell group including adjacent ones of a plurality of cell blocks and alternately sharing sub-word line drivers with adjacent cell groups; a mapping control circuit configured to generate a mapping control signal according to an output option signal, while selectively inverting at least one bit of the mapping control signal based on a row address and a repair control signal including information on a repaired cell group among the plurality of cell groups; and a mapping circuit configured to select one of two adjacent cell groups based on respective bits of the mapping control signal, and to map selected cell groups to a plurality of data pads.

According to embodiments of the present disclosure, the memory device may prevent the occurrence of an uncorrectable error (UE) and maximize the error correction capability by confining the maximum number of error bits including the miscorrection, within the range defined by the specification.

According to embodiments of the present disclosure, the memory device may provide optimized reliability, accessibility, and serviceability (RAS) operation by increasing the error relief capability of the memory controller.

These and other features and advantages of the embodiments of the present disclosure will become apparent to those skilled in the art from the following detailed description in conjunction with the following drawings.

### BRIEF DESCRIPTION OF THE DRAWINGS

FIG. 1 is a block diagram illustrating a memory system according to an embodiment of the present disclosure.
FIG. 2 is a diagram illustrating a data input/output operation of a memory device of FIG. 1.
FIG. 3 is a block diagram illustrating a memory device of FIG. 1 according to an embodiment of the present disclosure.
FIGS. 4A to 4C are diagrams illustrating a memory cell array of FIG. 3 according to an embodiment of the present disclosure.
FIG. 5 is a diagram illustrating an example of a data input/output path including the memory cell array and a mapping circuit shown in FIG. 3.
FIG. 6 is a detailed block diagram illustrating a mapping control circuit shown in FIG. 3.
FIG. 7 is a table for describing an operation of a repair group detector shown in FIG. 6.
FIG. 8 is a flowchart for describing an operation of a switch determinator shown in FIG. 6.
FIGS. 9A and 9B are tables for facilitating a description of an operation of FIG. 8.
FIGS. 10A to 11C are diagrams for describing a mapping operation in accordance with an embodiment of the present disclosure.
FIG. 12 is a block diagram illustrating a memory system including a memory module according to an embodiment of the present disclosure.
FIG. 13 is a block diagram illustrating a memory system including a stacked memory device according to an embodiment of the present disclosure.
FIG. 14 is a block diagram illustrating a mobile system including a memory device according to an embodiment of the present disclosure.

### DETAILED DESCRIPTION

Various embodiments of the present disclosure will be described below in more detail with reference to the accompanying drawings. The embodiments of the present disclosure may, however, be in different forms and should not be construed as limited to the embodiments set forth herein. Rather, these embodiments are provided so that this disclosure will be thorough and complete, and will fully convey the scope of the present disclosure to those skilled in the art. Throughout this disclosure, like reference numerals refer to like parts throughout the various figures and embodiments of the present disclosure.

It will be understood that when an element is referred to as being "coupled" or "connected" to another element, it may mean that the two are directly coupled or the two are electrically connected to each other with another circuit intervening therebetween. It will be further understood that the terms "comprise", "include", "have", etc. when used in this specification, specify the presence of stated features, numbers, steps, operations, elements, components, and/or combinations of them but do not preclude the presence or addition of one or more other features, numbers, steps, operations, elements, components, and/or combinations thereof. In the present disclosure, the singular forms are intended to include the plural forms as well, unless the context clearly indicates otherwise.

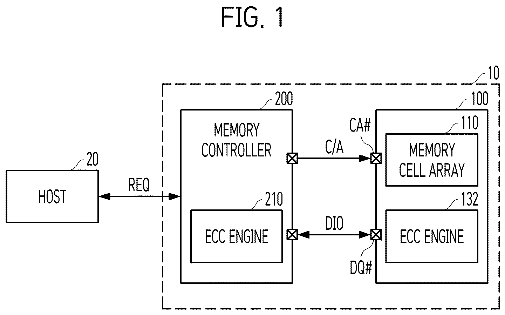

FIG. 1 is a block diagram illustrating a memory system 10 according to an embodiment of the present disclosure.

Referring to FIG. 1, the memory system 10 may include a memory device 100 and a memory controller 200. The memory system 10 may store data under the control of a host 20, such as a cellular phone, a smartphone, an MP3 player, a laptop computer, a desktop computer, a game player, a TV, a tablet PC, or an in-vehicle infotainment system. The host 20 may be an external device of the memory system 10.

The memory controller 200 may control operations of the memory system 10 and control data transfer between the host 20 and the memory device 100. The memory controller 200 may generate a command/address signal C/A according to a request REQ from the host 20 and provide the generated command/address signal C/A to the memory device 100. According to an embodiment, the memory controller 200 may provide a clock together with the command/address signal C/A. The memory controller 200 may provide data DIO corresponding to the request REQ from the host 20 to the memory device 100, and provide the data DIO read from the memory device 100 to the host 20. For example, the memory controller 200 may provide a write command, address, and data to the memory device 100 during a write operation. During a read operation, the memory controller 200 may provide a read command and address to the memory device 100 and provide data read from the memory device 100 to the host 20.

The memory controller 200 may include an error correction code (ECC) engine 210. The ECC engine 210 may detect and correct an error in the data DIO read from the memory device 100 and provide error-corrected data to the host 20. When the number of error bits of the data DIO exceeds an error correction capability of the ECC engine 210, the memory controller 200 may notify the host 20 that an uncorrectable error (UE) has occurred.

The memory device 100 may store the data DIO. The memory device 100 may operate under the control of the memory controller 200. The memory device 100 may include a memory cell array 110 including a plurality of memory cells that store data. The memory device 100 may include dynamic random access memory (DRAM) including dynamic memory cells. In an embodiment, the memory device 100 may be a double data rate synchronous dynamic random access memory (DDR SDRAM), a low power double data rate (LPDDR) type SDRAM, a graphics double data rate (GDDR) SDRAM, a Rambus dynamic random access memory (RDRAM), or others.

The memory device 100 is configured to receive the command/address signal C/A from the memory controller 200 to access an area selected from the memory cell array 110. That is, the memory device 100 may perform an operation instructed by a command on the area selected by an address. For example, the memory device 100 may perform a write operation (e.g., program operation) to write data DIO to the area selected by the address. During a read operation, the memory device 100 may read data DIO from the area selected by the address.

Further, the memory device 100 may include an ECC engine 132. The ECC engine 132 disposed within the memory device 100 may be referred to as an "on-die (or on-chip) ECC engine". During a write operation, the ECC engine 132 may generate an error correction code using the data DIO, and store the data DIO and the error correction code in a selected region of the memory cell array 110. During a read operation, the ECC engine 132 may read the data and the error correction code from a selected region of the memory cell array 110, and generate error-corrected data DIO by correcting an error in the read data using the read error correction code. The error correction capability of the memory device 100 may be set to be smaller than that of the memory controller 200. That is, the ECC engine 210 of the memory controller 200 may have the error correction capability greater than the ECC engine 132 of the memory device 100. For example, the ECC engine 132 may be capable of correcting only a single-bit error, whereas the ECC engine 210 may be capable of correcting a multi-bit error.

In memory device 100, command/address pads CA# for receiving the command/address signal C/A and data pads DQ# for receiving the data DIO may be disposed. Although only one command/address pad CA# and one data pad DQ# are illustrated in FIG. 1, the command/address pads CA# and the data pads DQ# may be disposed in a number corresponding to the number of bits of the command/address signal C/A and the data DIO, respectively.

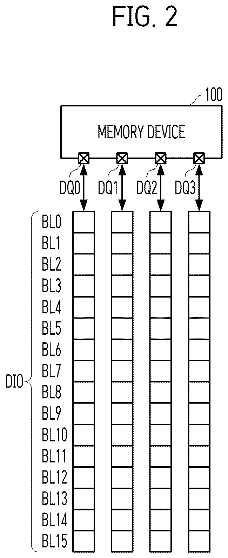

FIG. 2 is a diagram illustrating a data input/output operation of the memory device 100 of FIG. 1.

Referring to FIG. 2, the memory device 100 may use a number of data pads (i.e., the first to fourth data pads DQ0 to DQ3) corresponding to a data bus width (e.g., ×4) to input/output data DIO according to a preset data width option (e.g., 4 bits). In addition, the memory device 100 may perform a burst operation for converting data output from the memory cell array in parallel into a serial order, and outputting the converted data during a preset burst length (e.g., 16).

Accordingly, the memory device 100 of FIG. 2 may input/output the data DIO of 4*16 = 64 bits during a single read operation or write operation by inputting/outputting data in units of 4 bits through the first to fourth data pads DQ0 to DQ3 during each of the burst lengths BL0 to BL15. Meanwhile, if the error correction capability of the memory controller 200 can cover error bits in consecutive 32-bit data, the error bits transmitted through two data pads may be corrected by an error correction operation performed by the memory controller 200.

The memory device 100 of FIG. 2 illustrates a case where the data width option is set to 4 and the burst length is set to 16, and however the embodiments are not limited thereto. Various bit numbers of data may be input and output according to the setting of the data width option and the burst length.

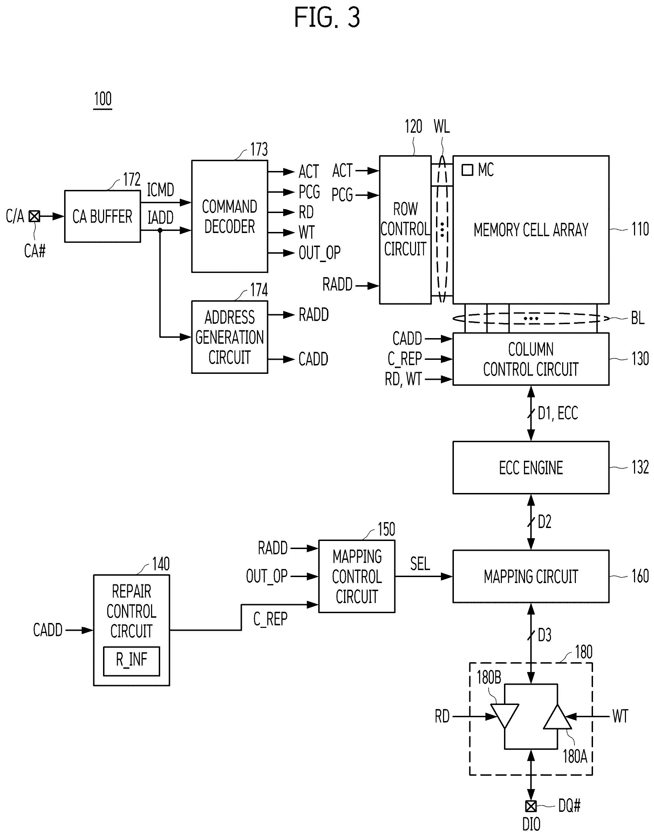

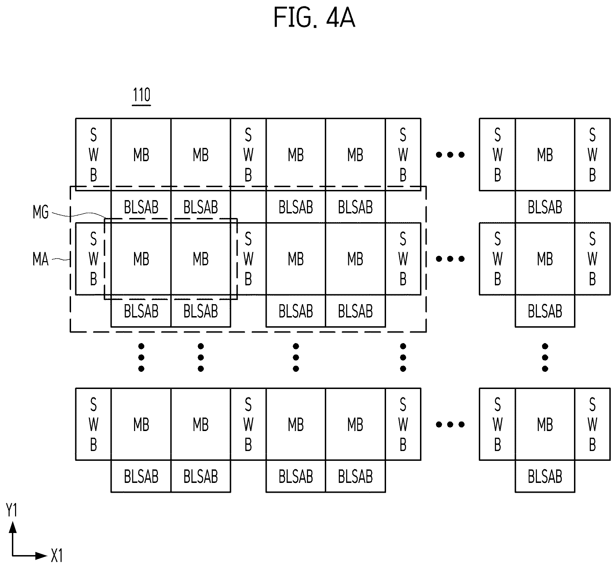

FIG. 3 is a block diagram illustrating the memory device 100 of FIG. 1 according to an embodiment of the present disclosure. FIGS. 4A to 4C are diagrams illustrating the memory cell array 110 of FIG. 3 according to an embodiment of the present disclosure.

Referring to FIG. 3, the memory device 100 may include the memory cell array 110, a row control circuit 120, a column control circuit 130, an error correction code (ECC) engine 132, a repair control circuit 140, a mapping control circuit 150, a mapping circuit 160, a command/address (CA) buffer 172, a command decoder 173, an address generation circuit 174, and a data input/output circuit 180.

The memory cell array 110 may be coupled to the row control circuit 120 through a plurality of word lines WL, and may be coupled to the column control circuit 130 through a plurality of bit lines BL. The plurality of word lines WL may extend in a first direction (e.g., a row direction) and are sequentially arranged in a second direction (e.g., a column direction). The plurality of bit lines BL may extend in the column direction and are sequentially arranged in the row direction.

Referring to FIG. 4A, the memory cell array 110 may include a plurality of memory blocks (hereinafter, referred to as "cell blocks MB"), respectively arranged in an array form in a first direction X1 and a second direction Y1 intersecting the first direction X1. Each cell block MB may include a plurality of memory cells MC connected between the plurality of word lines WL and the plurality of bit lines BL. In an embodiment of the present disclosure, the "cell block" may be defined as a set of memory cells that share the word lines WL and the bit lines BL and are arranged in the same form.

Meanwhile, in order to reduce delay in the delivery of a word line voltage, which increases as the number of memory cells connected to the word lines increases and a distance between the word lines decreases, one main word line may be divided into a plurality of sub-word lines (e.g., eight sub-word lines) and each sub-word line may be driven using sub-word line drivers. The plurality of word lines WL mentioned in the present disclosure may correspond to sub-word lines.

In the embodiment of FIG. 4A, two adjacent cell blocks among the cell blocks MB disposed in the first direction X1 may form one cell group MG. That is, the cell blocks MB disposed in the first direction X1 may be grouped into a plurality of cell groups MG. Sub-word line driver regions SWB may be arranged between cell groups MG disposed in the first direction X1. A plurality of sub-word line drivers may be disposed in the sub-word line driver region SWB. Bit line sense amplifier regions BLSAB may be arranged between cell blocks MB disposed in the second direction Y1. A plurality of bit line sense amplifiers may be disposed in the bit line sense amplifier region BLSAB.

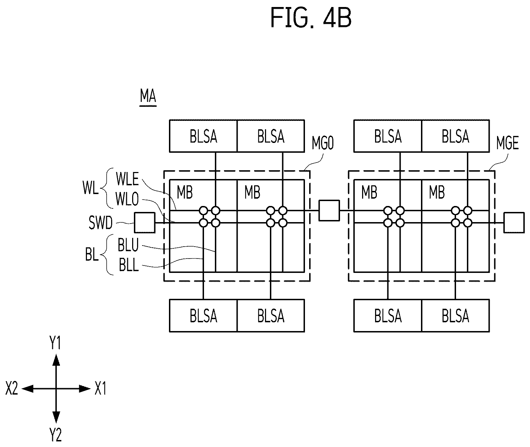

Referring to FIG. 4B, a partial area MA including two cell groups MG of FIG. 4A is shown.

The squares between the cell groups MG may represent the sub-word line drivers SWD, and the lines extending to the left and right of the sub-word line drivers SWD may represent the word lines (or sub-word lines). In reality, a much larger number of sub-word line drivers SWD and word lines exist, but only a part of the lines are shown to illustrate the simple structure for illustrative purpose.

Each of the cell groups MG may include odd-numbered word lines (hereinafter, referred to as "first word lines WLO") and even-numbered word lines (hereinafter, referred to as "second word lines WLE") extending in the first direction X1 and alternating with each other in the second direction Y1. In odd-numbered cell groups MGO, the first word lines WLO may share sub-word line drivers SWD with an adjacent cell group disposed in a direction X2 opposite to the first direction X1, and the second word lines WLE may share sub-word line drivers SWD with an adjacent cell group disposed in the first direction X1. Conversely, in even-numbered cell groups MGE, the first word lines WLO may share sub-word line drivers SWD with an adjacent cell group disposed in the first direction X1, and the second word lines WLE may share sub-word line drivers SWD with an adjacent cell group disposed in the direction X2. That is, since two adjacent cell groups MGO and MGE share the sub-word line drivers SWD, one sub-word line driver SWD may be allocated to four adjacent cell blocks MB disposed in the first direction X1.

Each of the cell blocks MB may include first bit lines BLU and second bit lines BLL extending in the second direction Y1 and alternately disposed in the first direction X1. The first bit lines BLU may share bit line sense amplifiers BLSA with an adjacent cell block disposed in the second direction Y1, and the second bit lines BLL may share bit line sense amplifiers BLSA with an adjacent cell block disposed in a direction Y2 opposite to the second direction Y1. That is, since two adjacent cell blocks MB disposed in the second direction Y1 share the bit line sense amplifiers BLSA, one bit line sense amplifier BLSA may be allocated to two adjacent cell blocks MB disposed in the second direction Y1.

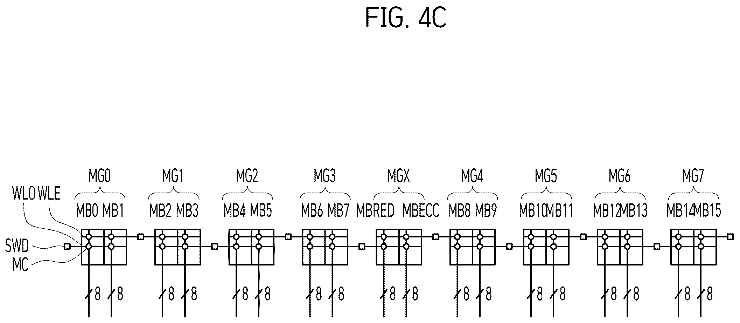

In the following embodiment, as illustrated in FIG. 4C, the memory cell array 110 is described, by way of example, as including first to sixteenth normal cell blocks MB0 to MB15, a redundancy cell block MBRED, and an error correction code (ECC) cell block MBECC, which are arranged in a row direction. Since every two adjacent cell blocks form one cell group, the first to sixteenth normal cell blocks MB0 to MB15 may constitute first to eighth normal cell groups MG0 to MG7. The redundancy cell block MBRED and the ECC cell block MBECC may form a separate cell group (hereinafter, referred to as an "extra cell group MGX"). Each of the cell groups MG0 to MG7 and MGX may share sub-word line drivers SWD alternately with adjacent cell groups. Due to an arrangement of nine cell groups in the row direction, five sub-word line drivers SWD may be disposed at the same level in the row direction.

The first to sixteenth normal cell blocks MB0 to MB15 serve as areas for storing user data D1 and constitute memory blocks that determine the storage capacity of the memory device 100. The ECC cell block MBECC may store an error correction code ECC generated by the ECC engine 132 for an error correction operation. The error correction code ECC may include known parity bits. The redundancy cell block MBRED is used for performing a repair operation for the first to sixteenth normal cell blocks MB0 to MB15 and the ECC cell block MBECC, and may include a plurality of redundancy cells for replacing defective cells among the normal cell blocks MB0 to MB15 and the ECC cell block MBECC.

During a read or write operation, each of the cell blocks MB0 to MB15, MBRED, and MBECC may input or output data in 8-bit units. That is, each cell block MB0 to MB15, MBRED, and MBECC may read 8-bit data from selected memory cells connected between a word line designated by a row address RADD and a predetermined number (e.g., eight) of bit lines designated by a column address CADD, or write 8-bit data to the selected memory cells. It is noted that, to select a word line designated by the row address RADD, all sub-word line drivers SWD located at the same level in the row direction may be activated.

Although only one redundancy cell block MBRED and one ECC cell block MBECC are illustrated in FIG. 4C, the present disclosure is not limited thereto, and one or more redundancy cell blocks MBRED and ECC cell blocks MBECC may be provided. The plurality of normal cell blocks MB0 to MB15 may be divided into an upper group including the first to eighth normal cell blocks MB0 to MB7 and a lower group including the ninth to sixteenth normal cell blocks MB8 to MB15. The first to eighth normal cell blocks MB0 to MB7, the redundancy cell block MBRED, the ECC cell block MBECC, and the ninth to sixteenth normal cell blocks MB8 to MB15 may be sequentially arranged in the row direction. However, the present disclosure is not limited thereto, and the first to sixteenth normal cell blocks MB0 to MB15, the redundancy cell block MBRED, and the ECC cell block MBECC may be arranged in various configurations.

Referring back to FIG. 3, the CA buffer 172 may receive a command/address signal C/A through command/address pads CA# from an external device (e.g., the memory controller 200 of FIG. 1). The CA buffer 172 may buffer the command/address signal C/A to output an internal command ICMD and an internal address IADD.

The command decoder 173 may decode the internal command ICMD to generate the active command ACT, the precharge command PCG, the write command WT, the read command RD, an output option signal OUT_OP, and the like. The active command ACT is a signal input when an active operation is instructed, the precharge command PCG is a signal input when a precharge operation is instructed, the write command WT is a signal input when a write operation is instructed, and the read command RD may be a signal input when a read operation is instructed. The output option signal OUT_OP is a signal used to select the half of the entire cell blocks MB in a configuration where a data bus width is set to ×4. For example, in response to the output option signal OUT_OP of a logic high level, one half of the entire cell blocks MB may be specified, and in response to the output option signal OUT_OP of a logic low level, the other half of the cell blocks MB may be specified. In the configuration where the data bus width is set to ×4, the memory device 100 may read data from the specified cell blocks to the first to fourth data pads DQ0 to DQ3, or write data from the first to fourth data pads DQ0 to DQ3 to the specified cell blocks, according to the output option signal OUT_OP. Meanwhile, the command decoder 173 may generate various commands necessary for operating the memory device in addition to the above-described commands; however, further description thereof will be omitted in order to focus on the core of the present disclosure.

The address generation circuit 174 may classify the internal address IADD received from the command decoder 173 into the row address RADD and the column address CADD. The row address RADD may be an address for selecting one of the plurality of word lines WL, and the column address CADD may be an address for selecting some bit lines on which a read operation and a write operation are to be performed among the plurality of bit lines BL. Each of the row address RADD and the column address CADD may include multiple bits. According to an embodiment, the address generation circuit 174 may classify some bits of the internal address IADD into a row address RADD, and classify the remaining bits into a column address CADD. Alternatively, the address generation circuit 174 may classify the address into a row address RADD when an active operation is instructed as a result of decoding the command decoder 173, and classify the address as a column address CADD when a read and write operation is instructed.

Depending on an embodiment, the memory cell array 110 may include a plurality of banks (not shown). When the memory cell array 110 is formed of a plurality of banks, the row control circuit 120 and the column control circuit 130 may be arranged in a number corresponding to the number of banks. The address generation circuit 174 may classify the internal address IADD into a bank address, a row address RADD, and a column address CADD, and one bank among the plurality of banks may be specified by the bank address. The number of banks or the number of memory cells MC may be determined according to the capacity of the memory device 100.

The row control circuit 120 may perform an active operation of activating a word line selected by the row address RADD in response to the active command ACT, and perform a precharge operation of precharging the activated word line in response to the precharge command PCG. The row control circuit 120 may drive a word line by controlling sub-word line drivers according to the row address RADD.

The column control circuit 130 may select some bit lines of the bit lines BL of the memory cell array 110 according to the column address CADD, perform a read operation of reading the data D1 and the error correction code ECC from the memory cells MC through the selected bit lines in response to the read command RD, or perform a write operation of writing the data D1 and the error correction code ECC to the memory cells MC through the selected bit lines in response to the write command WT. It is noted that a predetermined number of bit lines selected simultaneously may be defined as a column, and one column may be designated according to the column address CADD. The column control circuit 130 may control bit line sense amplifiers connected to the predetermined number of bit lines based on the column address CADD.

Meanwhile, the column control circuit 130 may perform a repair operation for, in response to a repair control signal C_REP designating a cell block (hereinafter referred to as a "defective cell block") in which a defective column is disposed, replacing data of the defective cell block with data of the redundancy cell block MBRED.

The ECC engine 132 may generate the error correction code ECC using data D2 received from the mapping circuit 160 during a write operation. The data D2 and the error correction code ECC output from the ECC engine 132 may be transferred to the column control circuit 130 and written to the memory cells MC. During a write operation, since only the error correction code ECC is generated without performing any error correction operation, the data D1 provided to the ECC engine 132 and the data D2 output from the ECC engine 132 may be the same. During a read operation, the ECC engine 132 may receive the data D1 and the error correction code ECC read from the memory cells MC, and correct an error in the read data D1 using the read error correction code ECC to output error-corrected data D2.

The repair control circuit 140 may store repair information R_INF for defective columns included in the plurality of cell blocks MB in the memory cell array 110, and generate the repair control signal C_REP based on the column address CADD and the stored repair information R_INF. The repair control circuit 140 may output the repair control signal C_REP that designates the defective cell block (i.e., a cell block including a defective column) by comparing the column address CADD with the stored repair information R_INF. For example, when 16 cell blocks MB are arranged and each cell block includes 128 columns, the column address CADD may be composed of 14 bits including 4 bits for designating a cell block MB and 7 bits for designating a column. When the repair information R_INF "0001 1000000" is stored and a column address CADD matching the repair information R_INF is input, the repair control circuit 140 may output a 5-bit repair control signal C_REP "1 0001" including 4 bits "0001" designating the defective cell block and a validity bit "1" indicating that the repair control signal is valid. The repair control signal C_REP designating the defective cell block may include information about a repaired cell group.

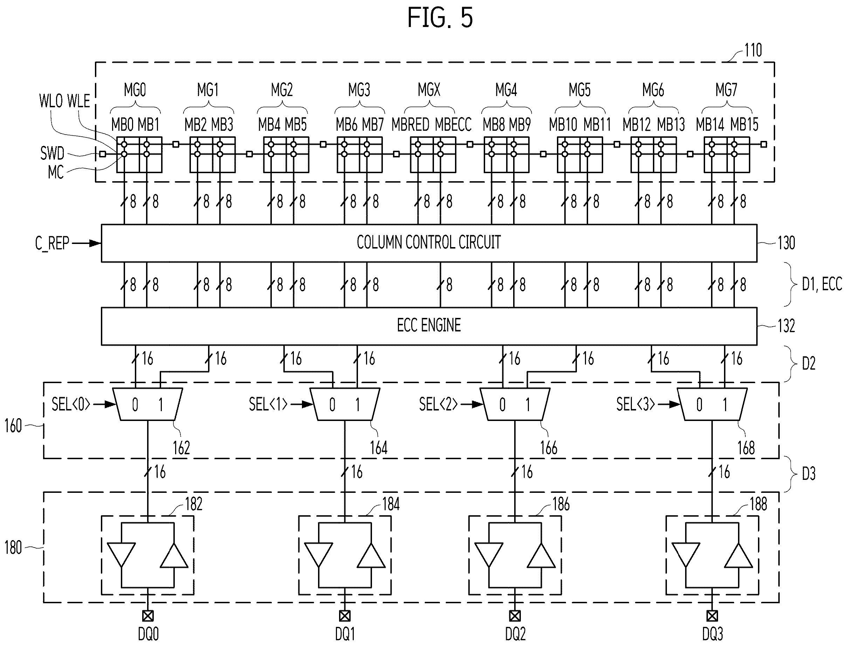

The mapping control circuit 150 may generate a mapping control signal SEL based on the output option signal OUT_OP, the row address RADD, and the repair control signal C_REP. The mapping control signal SEL is a signal for selecting one of two adjacent normal cell groups and may be composed of bits corresponding to the half of the normal cell groups arranged in the memory cell array 110. The mapping control circuit 150 may generate the mapping control signal SEL based on the output option signal OUT_OP, and may selectively invert at least one bit of the mapping control signal SEL based on the repair control signal C_REP and the row address RADD. Specifically, the mapping control circuit 150 may set the bits of the mapping control signal SEL to all-high bits or all-low bits according to the output option signal OUT_OP, while selectively inverting a bit corresponding to the repaired cell group, among the bits of the mapping control signal SEL, based on the repair control signal C_REP including information on the repaired cell group, and a specific bit of the row address RADD designating either an odd-numbered or even-numbered word line. A detailed configuration and operation of the mapping control circuit 150 will be described with reference to FIGS. 5 to 9B.

The mapping circuit 160 may be disposed between the ECC engine 132 and the data input/output circuit 180 to control a mapping between the memory cell array 110 and the plurality of data pads DQ#. The mapping circuit 160 may select one of two adjacent normal cell groups according to each bit of the mapping control signal SEL, and control the mapping between the selected cell groups and the plurality of data pads DQ#. For example, during a read operation, the mapping circuit 160 may map the error-corrected data D2 provided from the ECC engine 132 to data D3, and transfer the data D3 to the data input/output circuit 180, according to the mapping control signal SEL. For example, during a write operation, the mapping circuit 160 may map the data D3 transferred from the data input/output circuit 180 to the data D2, and transfer the data D2 to the ECC engine 132, according to the mapping control signal SEL. During the read operation, the mapping circuit 160 may map the error-corrected data D2 of 128-bit to the data D3 of 64-bit.

The data input/output circuit 180 may receive the data DIO from the memory controller 200, or transmit the data DIO to the memory controller 200, through the data pads DQ#. The data input/output circuit 180 may include a data input circuit 180A and a data output circuit 180B. The data input circuit 180A may receive the data DIO from the memory controller 200 as the data D2, according to the write command WT. The data input circuit 180A may transmit the data D2 by converting the data DIO that are input with a burst length 16 through each of the data pads DQ# in parallel. The data output circuit 180B may transmit the data D2 read from the memory cell array 110 as the data DIO to the memory controller 200, according to the read command RD. The data output circuit 180B may transmit the data DIO by converting the data D2 to the burst length 16 in series. Although the data input/output circuit 180 is illustrated as one configuration in FIG. 3, the data input/output circuit 180 may include a number of data input/output units corresponding to the number of the data pads DQ#.

Hereinafter, specific embodiments of the present disclosure will be described with reference to the drawings.

FIG. 5 is a diagram illustrating an example of a data input/output path including the memory cell array 110 and the mapping circuit 160 shown in FIG. 3.

Referring to FIG. 5, in the memory cell array 110, the first to eighth normal cell blocks MB0 to MB7, the redundancy cell block MBRED, the ECC cell block MBECC, and the ninth to sixteenth normal cell blocks MB8 to MB15 may be sequentially arranged in the row direction. During a read or write operation, each of the cell blocks MB0 to MB15, MBRED, and MBECC may input or output data in 8-bit units.

As described with reference to FIG. 4C, the first to sixteenth normal cell blocks MB0 to MB15 may form the first to eighth normal cell groups MG0 to MG7, and the redundancy cell block MBRED and the ECC cell block MBECC may form the extra cell group MGX. However, the present disclosure is not limited to such an arrangement. In the embodiment of the present disclosure, the normal cell blocks MB8 to MB15, the redundancy cell block MBRED, and the ECC cell block MBECC may be arranged in various ways, and in this case, the redundancy cell block MBRED and the ECC cell block MBECC may form a single cell group.

The column control circuit 130 may perform a repair operation that replaces the data of the defective cell block with the data of the redundancy cell block MBRED, according to the repair control signal C_REP designating the defective cell block. Accordingly, the data D1 of 128-bit and the error correction code ECC of 8-bit may be transferred between the column control circuit 130 and the ECC engine 132. Meanwhile, although the column control circuit 130 may control column selection and data direction based on the column address CADD, the read command RD, and the write command WT, descriptions of such operations are omitted for clarity of the invention.

The ECC engine 132 may generate the error correction code ECC using a check matrix, also referred to as an H-matrix, and may correct an error in the data D1 using the error correction code ECC. The ECC engine 132 may include a plurality of check matrix operation circuits (hereinafter referred to as "code operation circuits") on a cell block basis and may perform an error correction operation on a cell group basis. The code operation circuits may generate the error correction code ECC by applying known codes such as a BCH code, a Hamming code, or a Reed-Solomon (RS) code, or may apply other types of parity codes.

During a write operation, the ECC engine 132 may perform a matrix operation on the data D2 of 64-bit received from the mapping circuit 160 and the check matrix to generate the error correction code ECC of 8-bit. During a read operation, the ECC engine 132 may compare a result of a matrix operation on the data D1 of 128-bit and the error correction code ECC of 8-bit, which are received from the column control circuit 130, to generate a syndrome, and may correct an error in the data D1 based on the syndrome to output the error-corrected data D2 of 128-bit. Accordingly, between the ECC engine 132 and the mapping circuit 160, the data D2 may be transferred in 16-bit units on a cell group basis.

Meanwhile, since the number of bits of the data D2 input to and output from the ECC engine 132 differs between the read and write operations, the ECC engine 132 may generate the error correction code ECC using both the data D2 of 64-bit received from the mapping circuit 160 and the data D1 of 64-bit read from the memory cell array 110, and correct an error in the data D1 of 128-bit through a read-modify-write operation. Alternatively, the ECC engine 132 may generate the error correction code ECC by performing zero-padding on the data D2 of 64-bit, and correct an error in the data D1. Alternatively, two separate ECC engines may be deployed to independently perform an error correction operation for the data D1 of 64-bit output from one half of the cell groups and for the data D1 of 64-bit output from the other half of the cell groups.

The mapping circuit 160 may include first to fourth mappers 162 to 168 corresponding to two adjacent normal cell groups, respectively. The first to fourth mappers 162 to 168 may respectively correspond to bits of the mapping control signal SEL<3:0>, and may transfer data of one of two adjacent cell groups depending on the corresponding bit. For example, the first mapper 162 may correspond to the first and second normal cell groups MG0 and MG1 (or to the first to fourth normal cell blocks MB0 to MB3), and may select one of the first normal cell group MG0 and the second normal cell group MG1 based on the first bit SEL<0> of the mapping control signal SEL<3:0>, to transfer data of the selected normal cell group between the ECC engine 132 and the data input/output circuit 180. Similarly, the third mapper 166 may correspond to the fifth and sixth normal cell groups MG4 and MG5 (or to the ninth to twelfth normal cell blocks MB8 to MB11), and may select one of the fifth cell group MG4 and the sixth normal cell group MG5 based on the third bit SEL<2> of the mapping control signal SEL<3:0>, to transfer data of the selected normal cell group between the ECC engine 132 and the data input/output circuit 180. Accordingly, the first to fourth mappers 162 to 168 may map the error-corrected data D2 of 128-bit received from the ECC engine 132 into the data D3 of 64-bit, to thereby transfer the data D3 to the data input/output circuit 180, or may map the data D3 of 64-bit received from the data input/output circuit 180 into the data D2 of 128-bit, to thereby transfer the data D2 to the ECC engine 132.

The data input/output circuit 180 may include first to fourth data input/output units 182 to 188, each of which corresponds one-to-one with the first to fourth mappers 162 to 168 and the first to fourth data pads DQ0 to DQ3. Each data input/output unit 182 to 188 may receive and transfer the data DIO from the memory controller 200 through the corresponding data pad to the corresponding mapper, in response to the write command WT, or may transmit the data D3 received from the corresponding mapper to the memory controller 200 through the corresponding data pad, in response to the read command RD.

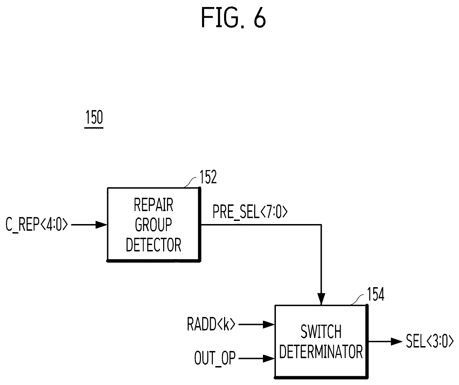

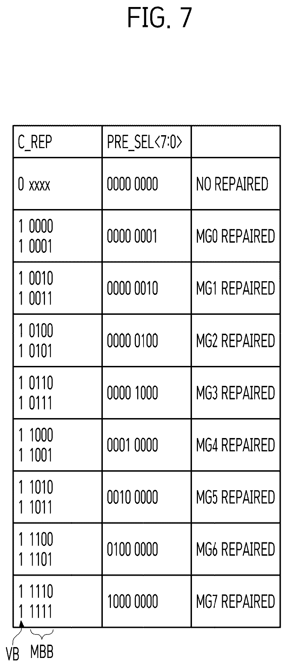

FIG. 6 is a detailed block diagram illustrating the mapping control circuit 150 shown in FIG. 3. FIG. 7 is a table for describing an operation of a repair group detector 152 shown in FIG. 6.

Referring to FIG. 6, the mapping control circuit 150 may include a repair group detector 152 and a switch determinator 154.

The repair group detector 152 may generate a preliminary control signal PRE_SEL<7:0> designating a repaired cell group, based on the repair control signal C_REP<4:0> designating a defective cell block. The repaired cell group refers to a cell group including the defective cell block, and the repair control signal C_REP<4:0> may include information on the repaired cell group. The preliminary control signal PRE_SEL<7:0> may be composed of bits corresponding respectively to the first to eighth normal cell groups MG0 to MG7.

As shown in FIG. 7, the repair control signal C_REP<4:0> may be composed of a 5-bit signal including cell block bits MBB designating the defective cell block and a validity bit VB indicating whether the repair control signal is valid. When the validity bit VD is a low bit, the repair group detector 152 may generate the preliminary control signal PRE_SEL<7:0> to have all-low bit, regardless of the cell block bits MBB. On the other hand, when the validity bit VD is a high bit, the repair group detector 152 may generate the preliminary control signal PRE_SEL<7:0> to designate a cell group including a cell block specified by the cell block bits MBB. For example, if the validity bit VD is a high bit and the cell block bits MBB are set to "0000" indicating that the first normal cell block MB0 is defective, or "0001" indicating that the second normal cell block MB1 is defective, the repair group detector 152 may generate the preliminary control signal PRE_SEL<7:0> of "0000 0001" to designate the first normal cell group MG0. As another example, if the validity bit VD is a high bit and the cell block bits MBB are set to "0100" indicating that the fifth normal cell block MB4 is defective, or "0101" indicating that the sixth normal cell block MB5 is defective, the repair group detector 152 may generate the preliminary control signal PRE_SEL<7:0> of "0000 0100" to designate the third normal cell group MG2.

The switch determinator 154 may generate the mapping control signal SEL<3:0> composed of all-high bits or all-low bits depending on the output option signal OUT_OP, while selectively switching (i.e., inverting) at least one bit of the mapping control signal SEL<3:0> based on either the preliminary control signal PRE_SEL<7:0> designating the repaired cell group, or a specific bit RADD<k> of the row address RADD, designating either an odd-numbered word line WLO or an even-numbered word line WLE.

Meanwhile, although, in FIG. 6, the repair group detector 152 is described as being included in the mapping control circuit 150, in other embodiments, the repair group detector 152 may be included in the repair control circuit 140, and the preliminary control signal PRE_SEL<7:0> designating the repaired cell group may be provided as a repair control signal.

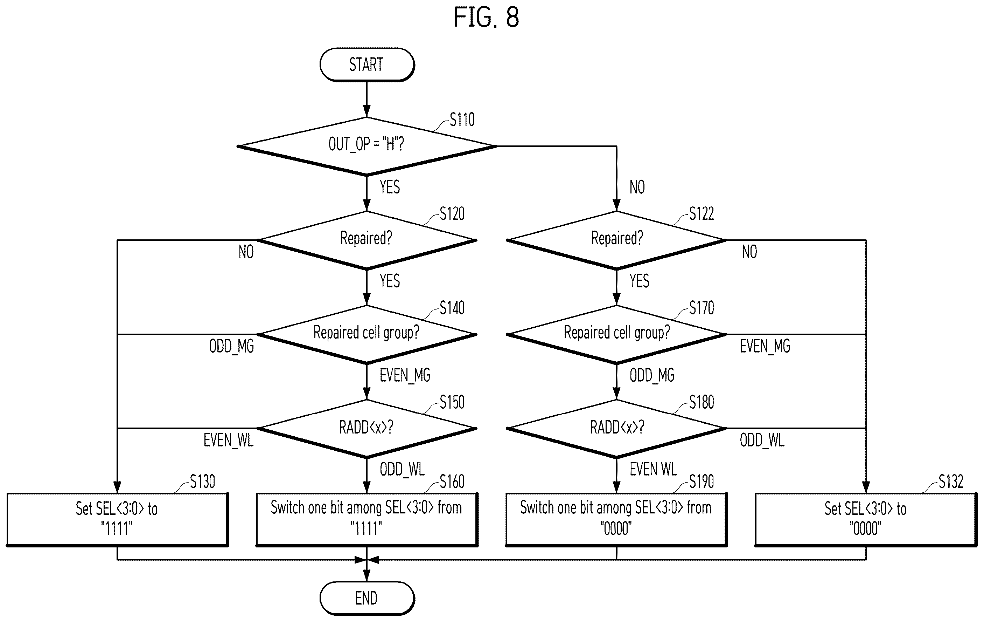

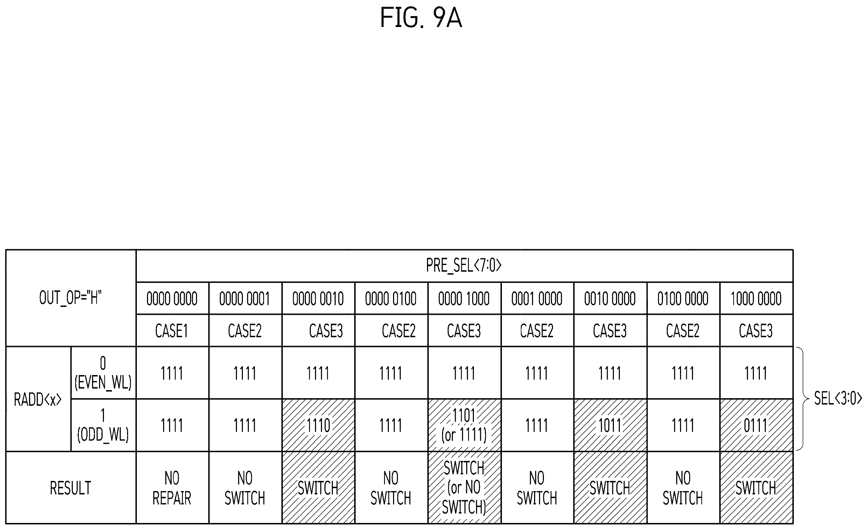

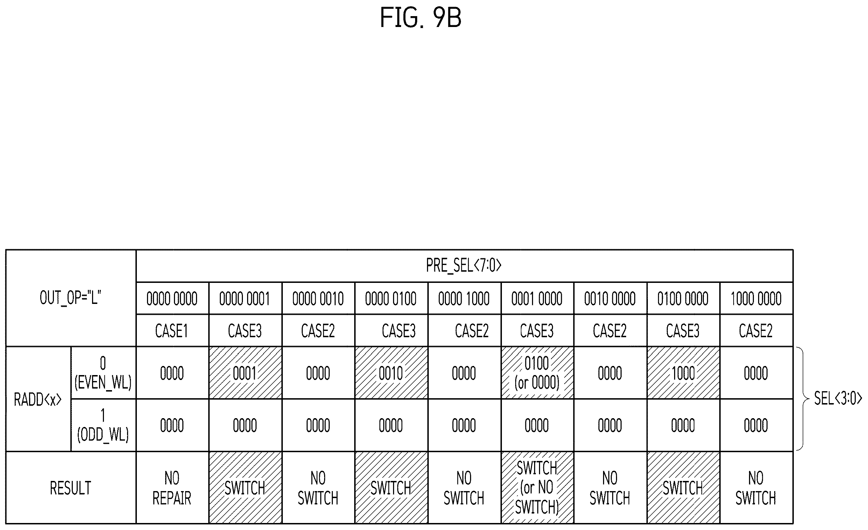

FIG. 8 is a flow chart for describing an operation of the switch determinator 154 shown in FIG. 6. FIGS. 9A and 9B are tables for facilitating a description of an operation of FIG. 8.

Referring to FIG. 8, when the output option signal OUT_OP is a logic high level (H) ("YES" in S110) and no repaired cell group exists ("NO" in S120), the switch determinator 154 may set the mapping control signal SEL<3:0> to "1111" (at S130) (see CASE 1 in FIG. 9A). For reference, the switch determinator 154 may determine that no repaired cell group exists when the preliminary control signal PRE_SEL<7:0> corresponding to all-low bits is input. The mapping circuit 160 may select even-numbered cell groups MG1, MG3, MG5, and MG7 among first to eighth normal cell groups MG0 to MG7, based on the mapping control signal SEL<3:0> of "1111".

When the output option signal OUT_OP is a logic high level ("YES" in S110) and a repaired cell group exists ("YES" in S120), the switch determinator 154 may determine whether the repaired cell group is included in odd-numbered cell groups MG0, MG2, MG4, and MG6, or in even-numbered cell groups MG1, MG3, MG5, and MG7, based on the preliminary control signal PRE_SEL<7:0> (at S140). When the repaired cell group is in the odd-numbered cell groups ("ODD_MG" in S140), the switch determinator 154 may set the mapping control signal SEL<3:0> to "1111" (at S130) (see CASE 2 in FIG. 9A).

When the repaired cell group is in the even-numbered cell groups ("EVEN_MG" in S140), the switch determinator 154 may verify whether the specific bit RADD<k> of the row address RADD designates the odd-numbered word line WLO or the even-numbered word line WLE (at S150). For example, the switch determinator 154 may determine that the specific bit RADD<k> designates the odd-numbered word line WLO when the specific bit RADD<k> is a high bit, and determine that the specific bit RADD<k> designates the even-numbered word line WLE the specific bit RADD<k> is a low bit. When the even-numbered word line WLE is designated ("EVEN_WL" in S150), the switch determinator 154 may set the mapping control signal SEL<3:0> to "1111" (at S130) (see an upper part of CASE 3 in FIG. 9A). In contrast, when the odd-numbered word line WLO is designated ("ODD_WL" in S150), the switch determinator 154 may switch (i.e., invert) a bit corresponding to the repaired cell group, among the bits of the mapping control signal SEL<3:0>, to a low bit (at S160) (see a lower part of CASE 3 in FIG. 9A). For example, when the repaired cell group is the second normal cell group MG1, the switch determinator 154 may generate the mapping control signal SEL<3:0> to "1110".

Depending on an embodiment, in case where the repaired cell group is an even-numbered cell group adjacent to the extra cell group MGX, the switch determinator 154 may not invert the bit corresponding to the repaired cell group. That is, when the repaired cell group is the fourth normal cell group MG3, the switch determinator 154 may generate the mapping control signal SEL<3:0> as either "1111" or "1101".

Meanwhile, when the output option signal OUT_OP is a logic low level ("NO" in S110) and no repaired cell group exists ("NO" in S122), the switch determinator 154 may set the mapping control signal SEL<3:0> to "0000" (at S132) (see CASE 1 in FIG. 9B). The mapping circuit 160 may select the odd-numbered cell groups MG0, MG2, MG4, and MG6 among the first to eighth normal cell groups MG0 to MG7, based on the mapping control signal SEL<3:0> of "0000".

When the output option signal OUT_OP is a logic low level ("NO" in S110) and a repaired cell group exists ("YES" in S122), the switch determinator 154 may determine whether the repaired cell group is included in the odd-numbered cell groups MG0, MG2, MG4, and MG6, or in the even-numbered cell groups MG1, MG3, MG5, and MG7, based on the preliminary control signal PRE_SEL<7:0> (at S170). When the repaired cell group is in the even-numbered cell groups (repaired cell group?) ("EVEN _MG" in S170), the switch determinator 154 may set the mapping control signal SEL<3:0> to "0000" (at S132) (see CASE 2 in FIG. 9B). When the repaired cell group is in the odd-numbered cell groups ("ODD_MG" in S170), the switch determinator 154 may determine whether the specific bit RADD<k> of the row address RADD designates the odd-numbered word line WLO or the even-numbered word line WLE (at S180). When the odd-numbered word line WLO is designated ("ODD_WL" in S180), the switch determinator 154 may set the mapping control signal SEL<3:0> to "0000" (at S132) (see a lower part of CASE 3 in FIG. 9B). In contrast, when the even-numbered word line WLE is designated ("EVEN_WL" in S180), the switch determinator 154 may switch (i.e., invert) a bit corresponding to the repaired cell group, among the bits of the mapping control signal SEL<3:0>, to a low bit (at S190) (see an upper part of CASE 3 in FIG. 9B). For example, when the repaired cell group is the third normal cell group MG2, the switch determinator 154 may generate the mapping control signal SEL<3:0> to "0010".

Depending on an embodiment, in an instance in which the repaired cell group is an odd-numbered cell group adjacent to the extra cell group MGX, the switch determinator 154 may not invert the bit corresponding to the repaired cell group. That is, when the repaired cell group is the fifth normal cell group MG4, the switch determinator 154 may generate the mapping control signal SEL<3:0> as either "0000" or "0100".

Hereinafter, referring now to FIGS. 6 to 9B, an operation of the mapping circuit 160 according to the mapping control signal SEL<3:0> will be described.

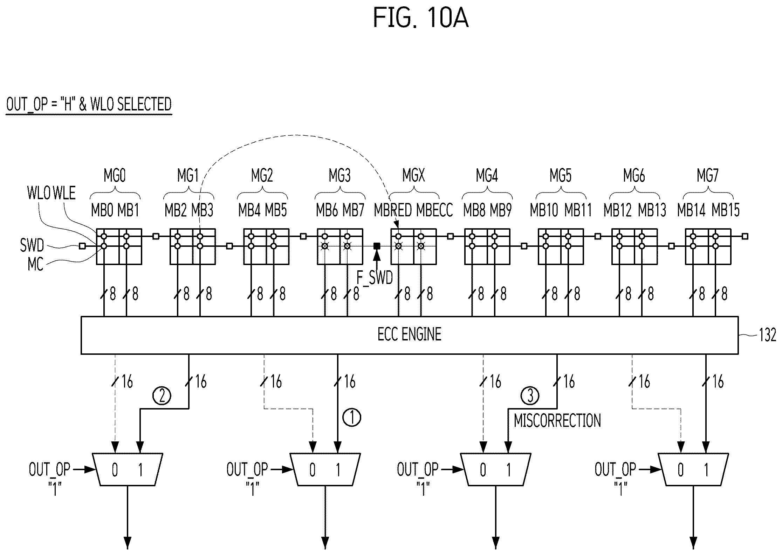

FIGS. 10A to 10C are diagrams illustrating mapping operations of the related art and an embodiment of the present disclosure when the output option signal OUT_OP is a logic high level. In FIGS. 10A to 10C, an example is illustrated in which a defective column included in the fourth normal cell block MB3 of the second normal cell group MG1 is repaired during a read operation.

Referring to FIG. 10A, a comparative example of the related art is illustrated, where the mapping circuit 160 operates in response to the output option signal OUT_OP of a logic high level when an odd-numbered word line WLO is designated by the row address RADD.

In the related art, the mapping circuit 160 selects the even-numbered cell groups MG1, MG3, MG5, and MG7 in response to the output option signal OUT_OP of a logic high level. As a result, the error-corrected data of 64-bit output from the even-numbered cell groups MG1, MG3, MG5, and MG7 may be output through the data pads.

At this time, if a defect occurs in a shared sub-word line driver F_SWD between the fourth normal cell group MG3 and the extra cell group MGX, error bits may occur in four cell blocks (e.g., MB6, MB7, MBRED, and MBECC) served by the shared defective sub-word line driver F_SWD. Due to the error bits in the ECC cell block MBECC, a miscorrection may occur in the ECC engine 132. As a result, in addition to the error bits in data (①) output from the fourth normal cell group MG3 and in data (②) output from the second normal cell group MG1 repaired by the redundancy cell block MBRED, the error bit may also occur in data (③) output from the sixth normal cell group MG5 due to the miscorrection. These error bits are output through three independent data pads and may exceed the error correction capability of the memory controller 200.

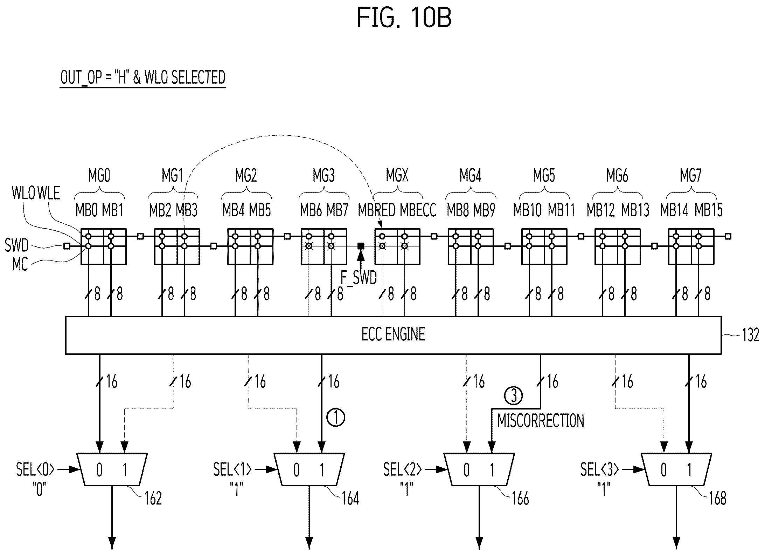

Referring to FIG. 10B, in accordance with an embodiment of the present disclosure, an operation of the mapping circuit 160 is illustrated, in which an odd-numbered word line WLO is designated by the row address RADD and the output option signal OUT_OP is a logic high level.

As described with reference to FIGS. 6 to 9B, when the output option signal OUT_OP is a logic high level and the odd-numbered word line WLO is designated, the mapping control circuit 150 may generate the mapping control signal SEL<3:0> of "1110" since the second normal cell group MG1 (i.e., the even-numbered group) is a repaired cell group. Accordingly, the second to fourth mappers 164 to 168 may select and output data from the even-numbered cell groups MG3, MG5, and MG7. In contrast, the first mapper 162 may select and output data from the first normal cell group MG0, which is the odd-numbered cell group, instead of the second normal cell group MG1. That is, in the embodiment of the present disclosure, even if a defect occurs in a shared sub-word line driver F_SWD between the fourth normal cell group MG3 and the extra cell group MGX, causing error bits in four cell blocks MB6, MB7, MBRED, and MBECC, an error bit in the data (②) output from the repaired second normal cell group MG1 may be eliminated.

Accordingly, in the embodiment of the present disclosure, the error bits may occur only in the data (①) output from the fourth normal cell group MG3 and in the data (③) output from the sixth normal cell group MG5 due to a miscorrection by the ECC engine 132. These error bits are output through two independent data pads and may be covered by the error correction capability of the memory controller 200.

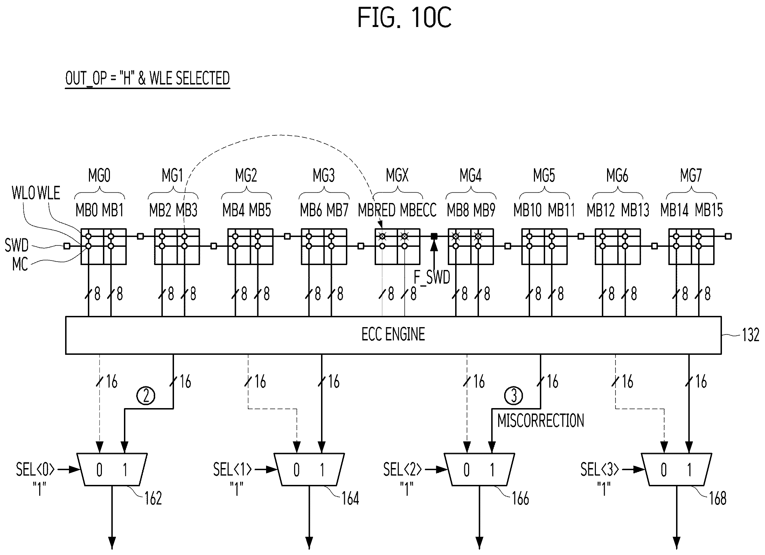

Meanwhile, referring to FIG. 10C, an operation of the mapping circuit 160 is illustrated when the row address RADD designates an even-numbered word line WLE and the output option signal OUT_OP is a logic high level.

When a defect occurs in a shared sub-word line driver F_SWD between the extra cell group MGX and the fifth normal cell group MG4, error bits may occur in four cell blocks MBRED, MBECC, MB8, and MB9 served by the shared defective sub-word line driver F_SWD. In this case, since data is not output from the fifth normal cell group MG4 including the ninth and tenth normal cell blocks MB8 and MB9, the error bit may occur in data (②) output from the repaired second normal cell group MG1 and in data (③) output from the sixth normal cell group MG5 due to the miscorrection. These error bits are output through two independent data pads and may be covered by the error correction capability of the memory controller 200.

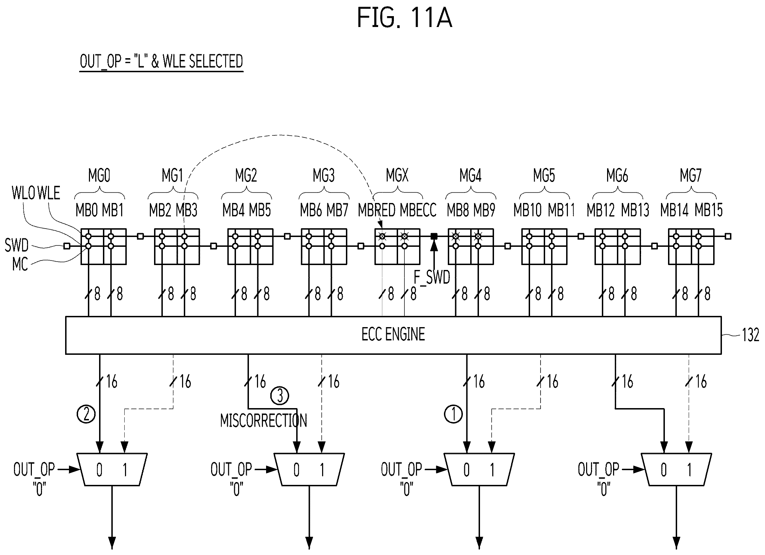

FIGS. 11A to 11C are diagrams illustrating mapping operations of the related art and an embodiment of the present disclosure when the output option signal OUT_OP is a logic low level. In FIGS. 11A to 11C, an example is illustrated in which a defective column included in the second normal cell block MB1 of the first normal cell group MG0 is repaired during a read operation.

Referring to FIG. 11A, an example of the related art is illustrated, where the mapping circuit 160 operates in response to the output option signal OUT_OP at a logic low level when an even-numbered word line WLE is designated by the row address RADD.

In the related art, the mapping circuit 160 selects the odd-numbered cell groups MG0, MG2, MG4, and MG6 in response to the output option signal OUT_OP of a logic low level. As a result, the error-corrected data of 64-bit output from the odd-numbered cell groups MG0, MG2, MG4, and MG6 may be output through the data pads.

At this time, if a defect occurs in a shared sub-word line driver F_SWD between the fifth normal cell group MG4 and the extra cell group MGX, error bits may occur in four cell blocks (e.g., MBRED, MBECC, MB8, and MB9) served by the shared defective sub-word line driver F_SWD. Due to the error bits in the ECC cell block MBECC, a miscorrection may occur in the ECC engine 132. As a result, in addition to the error bits in data (①) output from the fifth normal cell group MG4 and in data (②) output from the first normal cell group MG0 repaired by the redundancy cell block MBRED, the error bit may also occur in data (③) output from the third normal cell group MG2 due to the miscorrection. These error bits are output through three independent data pads and may exceed the error correction capability of the memory controller 200.

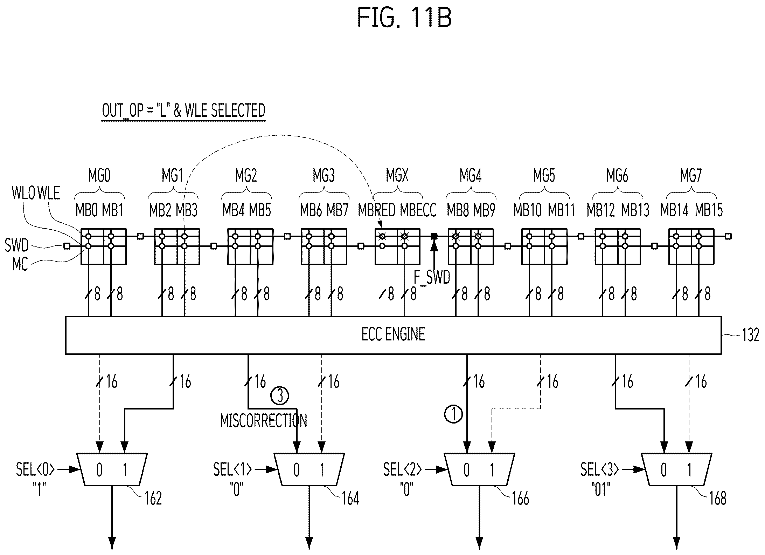

Referring to FIG. 11B, in accordance with an embodiment of the present disclosure, an operation of the mapping circuit 160 is illustrated, in which an even-numbered word line WLE is designated by the row address RADD and the output option signal OUT_OP is a logic low level.

As described with reference to FIGS. 6 to 9B, when the output option signal OUT_OP is a logic low level and the even-numbered word line WLE is designated, the mapping control circuit 150 may generate the mapping control signal SEL<3:0> of "0001" since the first normal cell group MG0 (i.e., the odd-numbered group) is a repaired cell group. Accordingly, the second to fourth mappers 164 to 168 may select and output data from the odd-numbered cell groups MG2, MG4, and MG6. In contrast, the first mapper 162 may select and output data from the second normal cell group MG0, which is the even-numbered group, instead of the first normal cell group MG0. That is, in the embodiment of the present disclosure, even if a defect occurs in a shared sub-word line driver F_SWD between the fifth normal cell group MG4 and the extra cell group MGX, causing error bits in four cell blocks MBRED, MBECC, MB8, and MB9, an error bit in the data (②) output from the repaired first normal cell group MG0 may be eliminated.

Accordingly, in the embodiment of the present disclosure, the error bits may occur only in the data (①) output from the fifth normal cell group MG4 and in the data (③) output from the third normal cell group MG2 due to a miscorrection by the ECC engine 132. These error bits are output through two independent data pads and may be covered by the error correction capability of the memory controller 200.

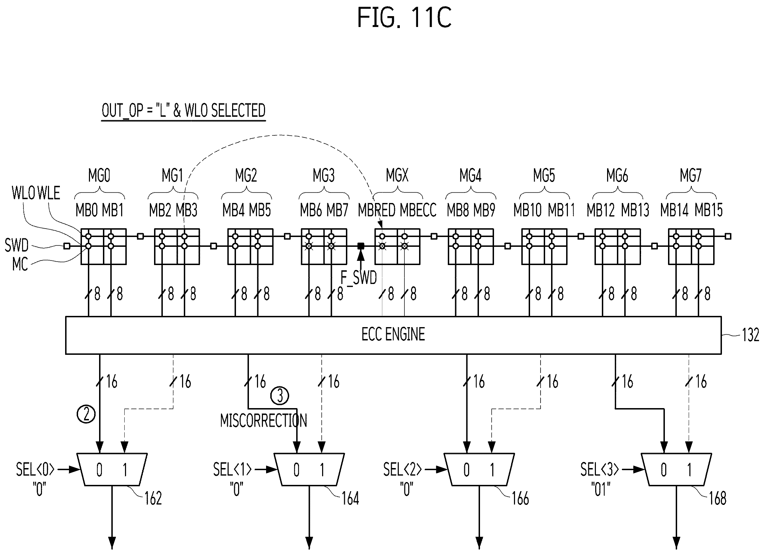

Meanwhile, referring to FIG. 11C, an operation of the mapping circuit 160 is illustrated when the row address RADD designates an odd-numbered word line WLO and the output option signal OUT_OP is a logic low level.

When a defect occurs in a shared sub-word line driver F_SWD between the fourth normal cell group MG3 and the extra cell group MGX, error bits may occur in four cell blocks MB6, MB7, MBRED, and MBECC served by the shared defective sub-word line driver F_SWD. In this case, since data is not output from the fourth normal cell group MG3 including the seventh and eighth normal cell blocks MB6 and MB7, the error bits may occur in data (②) output from the repaired first normal cell group MG0 and in data (③) output from the third normal cell group MG2 due to the miscorrection. These error bits are output through two independent data pads and may be covered by the error correction capability of the memory controller 200.

As described above, in an embodiment of the present disclosure, the memory device 100 may include a plurality of mappers corresponding respectively to a pair of odd-numbered and even-numbered normal cell groups. The memory device 100 may identify target cell groups from which data is to be output, from among the odd-numbered and even-numbered cell groups, based on the output option signal OUT_OP. The memory device 100 may determine whether a repaired cell group exists among the target cell groups based on the preliminary control signal PRE_SEL<7:0>, and may determine whether any of the target cell groups shares a sub-word line driver SWD with the extra cell group MGX based on the row address RADD. When the repaired cell group exists among the target cell groups, and a cell group that shares the sub-word line driver SWD with the extra cell group MGX also exists among the target cell groups, the memory device 100 may control the mapper corresponding to the repaired cell group to select a different cell group instead of the repaired cell group.

For example, when the even-numbered normal cell groups are target based on the output option signal OUT_OP, and both the repaired cell group and the cell group sharing the sub-word line driver SWD with the extra cell group MGX are included in the even-numbered normal cell groups, the mapper corresponding to the repaired cell group may be controlled to select an odd-numbered normal cell group, while the remaining mappers may be controlled to select the even-numbered normal cell groups. Alternatively, when the odd-numbered normal cell groups are identified based on the output option signal OUT_OP, and both the repaired cell group and the cell group sharing the sub-word line driver SWD with the extra cell group MGX are included in the odd-numbered normal cell groups, the mapper corresponding to the repaired cell group may be controlled to select an even-numbered normal cell group, while the remaining mappers may be controlled to select the odd-numbered normal cell groups.

Accordingly, the memory device 100 may prevent the occurrence of the uncorrectable error (UE) by confining the maximum number of error bits caused by the defective sub-word line driver within the error correction capability of the memory controller 200.

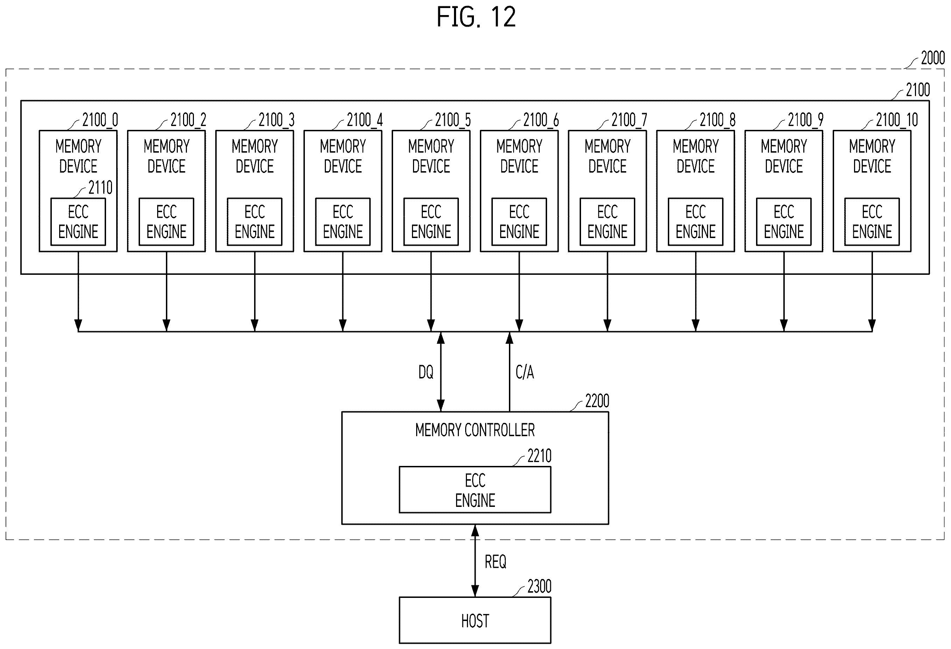

FIG. 12 is a block diagram illustrating a memory system 2000 including a memory module 2100 according to an embodiment of the present disclosure.

Referring to FIG. 12, the memory system 2000 may include the memory module 2100 and a memory controller 2200.

The memory controller 2200 may control operations of the memory system 2000 and control a data transfer between a host 2300 and the memory module 2100. The memory controller 2200 may generate a command/address signal C/A according to a request REQ from the host 2300 to provide the command/address signal C/A to the memory module 2100, and provide data DIO corresponding to the request REQ from the host 2300 to the memory module 2100, and provide data DIO read from the memory module 2100 to the host 2300. The memory controller 2200 may include an error correction code (ECC) engine 2210. The ECC engine 2210 may detect and correct an error in the data DIO read from the memory module 2100 and provide error-corrected data to the host 2300. When the number of error bits of the data DIO exceeds an error correction capability of the ECC engine 2210, the memory controller 2200 may notify the host 2300 that an uncorrectable error (UE) has occurred.

The memory module 2100 may include a plurality of memory devices 2100_0 to 2100_10. Each of the memory devices 2100_0 to 2100_10 may include an error correction code (ECC) engine 2110. Each of the memory devices 2100_0 to 2100_10 may correspond to the memory device 100 described in FIG. 3. In an embodiment of the present disclosure, each of the memory devices 2100_0 to 2100_10 may include components, such as described herein above with respect to the present disclosure, including: a memory cell array including a plurality of normal cell blocks, a redundancy cell block, and an ECC cell block, wherein adjacent ones of the normal cell blocks form a plurality of normal cell groups, and the redundancy cell block and the ECC cell block form an extra cell group; a mapping circuit including a plurality of mappers that correspond respectively to a pair of the normal cell groups and select one of the normal cell groups included in a corresponding pair based on respective bits of a mapping control signal; and a mapping control circuit that identifies target cell groups from which data is to be output, among the normal cell groups, according to (for example, based on) an output option signal, and controls the respective bits of the mapping control signal to have different values by detecting whether a repaired cell group is included in the target cell groups, and whether a cell group that shares a sub-word line driver with the extra cell group is also included in the target cell groups. As a result, the number of error bits that may occur due to a defective sub-word line driver may be limited within the error correction capability of the memory controller, thereby preventing the occurrence of uncorrectable error (UE).

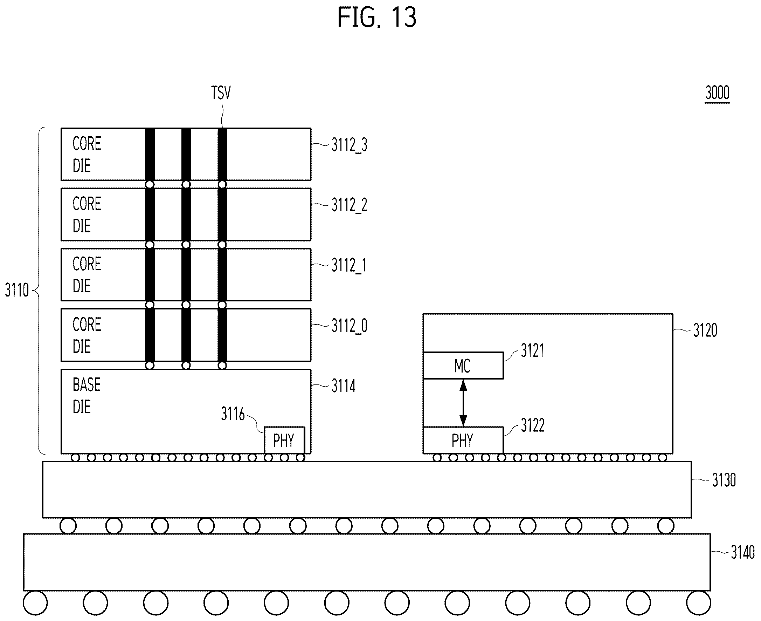

FIG. 13 is a block diagram illustrating a memory system 3000 including a stacked memory device 3110 according to an embodiment of the present disclosure.

Referring to FIG. 13, the memory system 3000 may include a package substrate 3140, an interposer 3130, a stacked memory device 3110, and a processor 3120.

The package substrate 3140 may include a printed circuit board (PCB). The package substrate 3140 may be electrically connected to an external system board, main board, or module board through bumps.

The interposer 3130 may be formed on the package substrate 3140. The interposer 3130 may be a silicon substrate in which only wiring is formed.

The stacked memory device 3110 and the processor 3120 may be formed on the interposer 3130. The stacked memory device 3110 and the processor 3120 may be disposed on the interposer 3130 spaced apart from each other. Although one stacked memory device 3110 is illustrated in FIG. 13, the embodiments of the present disclosure are not limited thereto, and one or more stacked memory devices may be formed on the interposer 3130 around a processor 3120.

The processor 3120 may include a memory controller (MC) 3121 and a physical interface circuit (PHY) 3122. The memory controller 3121 may be configured to control the stacked memory device 3110. The physical interface circuit 3122 may interface between the memory controller 3121 and the stacked memory device 3110. The physical interface circuit 3122 may be an interface circuit that converts signals transferred from the memory controller 3121 into signals suitable for use in the stacked memory device 3110 and converts the signals transferred from the stacked memory device 3110 into signals suitable for use in the memory controller 3121. The processor 3120 may be one of various processors such as a micro-processing unit (MPU), a central processing unit (CPU), a general processing unit (GPU), and a host processing unit (HPU).

The stacked memory device 3110 may include a lower chip 3114 and one or more upper chips 3112 vertically stacked on the interposer 3130. An example of the stacked memory device 3110 formed by stacking a plurality of chips as described above may be a high bandwidth memory (HBM). Through electrodes TSV are formed between the lower chip 3114 and the upper chips 3112, through which signals (i.e., commands, addresses, and data) may be transferred between the chips.

The lower chip 3114 may include a physical interface circuit (PHY) 3116 for an interface with the memory controller 3121. Each of the upper chips 3112 may correspond to the memory device 100 described in FIG. 3. That is, each of the upper chips 3112 may include: a memory cell array including a plurality of normal cell blocks, a redundancy cell block, and an ECC cell block, wherein adjacent ones of the normal cell blocks form a plurality of normal cell groups, and the redundancy cell block and the ECC cell block form an extra cell group; a mapping circuit including a plurality of mappers that correspond respectively to a pair of the normal cell groups and select one of the normal cell groups included in a corresponding pair based on respective bits of a mapping control signal; and a mapping control circuit that identifies target cell groups from which data is to be output, among the normal cell groups, according to an output option signal, and controls the respective bits of the mapping control signal to have different values by detecting whether a repaired cell group is included in the target cell groups, and whether a cell group that shares a sub-word line driver with the extra cell group is also included in the target cell groups. As a result, the number of error bits that may occur due to a defective sub-word line driver may be limited within the error correction capability of the memory controller, thereby preventing the occurrence of uncorrectable error (UE).

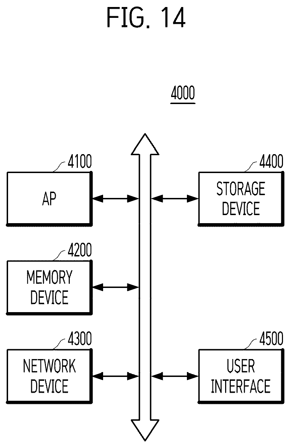

FIG. 14 is a block diagram illustrating a mobile system 4000 including a memory device 4200 according to an embodiment of the present disclosure.

Referring to FIG. 14, the mobile system 4000 may include an application processor (AP) 4100, the memory device 4200, a network device 4300, a storage device 4400, and a user interface 4500.

The application processor 4100 may drive components, an operating system (OS), or a user program included in the mobile system 4000. For example, the application processor 4100 may be provided as a system-on-chip (SoC).

The memory device 4200 may operate as a main memory, an operation memory, a buffer memory, or a cache memory of the mobile system 4000. The memory device 4200 may include a volatile random access memory such as DRAM, SDRAM, DDR SDRAM, DDR2 SDRAM, DDR3 SDRAM, Low-Power Double Data Rate 3 Synchronous Dynamic Random-Access Memory (LPDDR3 SDRAM), or a nonvolatile random access memory such as phase-change RAM (PRAM), Resistive Random-Access Memory (ReRAM), Magnetoresistive Random-Access Memory (MRAM), Ferroelectric RAM (FRAM), etc. According to an embodiment, the memory device 4200 may be configured as the memory system 2000 described with reference to FIG. 12.

In an embodiment of the present disclosure, the memory device 4200 may correspond to the memory device 100 described in FIG. 3. That is, the memory device 4200 may include: a memory cell array including a plurality of normal cell blocks, a redundancy cell block, and an ECC cell block, wherein adjacent ones of the normal cell blocks form a plurality of normal cell groups, and the redundancy cell block and the ECC cell block form an extra cell group; a mapping circuit including a plurality of mappers that correspond respectively to a pair of the normal cell groups and select one of the normal cell groups included in a corresponding pair based on respective bits of a mapping control signal; and a mapping control circuit that identifies target cell groups from which data is to be output, among the normal cell groups, according to an output option signal, and controls the respective bits of the mapping control signal to have different values by detecting whether a repaired cell group is included in the target cell groups, and whether a cell group that shares a sub-word line driver with the extra cell group is also included in the target cell groups. As a result, the number of error bits that may occur due to a defective sub-word line driver may be limited within the error correction capability of the memory controller, thereby preventing the occurrence of uncorrectable error (UE). According to an embodiment, the memory device 4200 may be configured with the memory system 2000 described with reference to FIG. 12.

The network device 4300 may communicate with external devices. For example, the network device 4300 may support wireless communication such as Code Division Multiple Access (CDMA), Global System for Mobile Communication (GSM), Wideband CDMA (WCDMA), CDMA-2000, Time Division Multiple Access (TDMA), Long Term Evolution (LTE), Worldwide Interoperability for Microwave Access (WiMAX), Wireless Local Area Network (WLAN), Ultra-Wideband (UWB), Bluetooth, Wi-Fi, etc. For example, the network device 4300 may be included in the application processor 4100.

The storage device 4400 may store data. For example, the storage device 4400 may store data received from the application processor 4100. Alternatively, the storage device 4400 may transmit the stored data to the application processor 4100. For example, the storage device 4400 may be implemented as a nonvolatile semiconductor memory device such as a phase-change RAM (PRAM), a magnetic RAM (MRAM), a resistive RAM (RRAM), a NAND flash, and a three-dimensional NAND flash.

While the embodiments of the present disclosure have been described with respect to the specific embodiments, it will be apparent to those skilled in the art that various changes and modifications may be made without departing from the spirit and scope of the invention as defined in the following claims. Furthermore, the embodiments may be combined to form additional embodiments.

## Claims

1. A memory device comprising:
a memory cell array including a plurality of cell groups, each cell group including adjacent ones of a plurality of cell blocks and alternately sharing sub-word line drivers with adjacent cell groups;
a mapping control circuit configured to generate a mapping control signal according to an output option signal, while selectively inverting at least one bit of the mapping control signal based on a row address and a repair control signal including information on a repaired cell group among the plurality of cell groups; and
a mapping circuit configured to select one of two adjacent cell groups based on respective bits of the mapping control signal, and to map selected cell groups to a plurality of data pads.

2. The memory device of claim 1, wherein the mapping control circuit is configured to set the respective bits of the mapping control signal to all-high bits or all-low bits according to the output option signal, while selectively inverting a bit corresponding to the repaired cell group based on a specific bit of the row address and the repair control signal, the specific bit of the row address designating an odd-numbered word line or even-numbered word line.

3. The memory device of claim 1, wherein, in a configuration where a data bus width is set to ×4, the output option signal is externally provided to identify half of the plurality of cell blocks.

4. The memory device of claim 1, wherein the mapping control circuit includes:
a repair group detector configured to generate a preliminary control signal designating the repaired cell group, based on the repair control signal; and
a switch determinator configured to set the respective bits of the mapping control signal to all-high bits or all-low bits according to the output option signal, while selectively inverting a bit corresponding to the repaired cell group, based on a specific bit of the row address and the repair control signal, the specific bit of the row address designating an odd-numbered word line or even-numbered word line.

5. The memory device of claim 1, further comprising a repair control circuit configured to store repair information on defective columns included in the plurality of cell blocks, and to compare a column address with the stored repair information to generate the repair control signal.

6. The memory device of claim 1,
wherein the plurality of cell blocks includes first to 4n-th normal cell blocks, a redundancy cell block, and an error correction code (ECC) cell block, which are arranged in a first direction, n being an integer equal to or greater than 1, and
wherein adjacent ones of the first to 4n-th normal cell blocks are grouped to form first to 2n-th normal cell groups, and the redundancy cell block and the ECC cell block are grouped to form an extra cell group.

7. The memory device of claim 6, wherein the mapping control circuit is configured to:
identify n normal cell groups among the first to 2n-th normal cell groups according to the output option signal; and
detect that the repaired cell group is included in the n normal cell groups and that one of the n normal cell groups shares the sub-word line drivers with the extra cell group based on the repair control signal and the row address to invert a bit of the mapping control signal, corresponding to the repaired cell group.

8. The memory device of claim 6, wherein the mapping circuit includes first to n-th mappers respectively corresponding to two adjacent normal cell groups, each mapper configured to select one of the two adjacent normal cell groups based on a corresponding bit of the mapping control signal.

9. The memory device of claim 6, wherein the first to n-th normal cell groups, the extra cell group, and the (n+1)-th to 2n-th normal cell groups are sequentially arranged in the first direction.

10. The memory device of claim 6, further comprising:
a column control circuit configured to replace a defective column included in the first to 4n-th normal cell blocks with a redundancy column of the redundancy cell block based on the repair control signal; and
an ECC engine configured to correct an error of data output from the first to 4n-th normal cell blocks based on an ECC output from the ECC cell block,
wherein the mapping circuit is disposed between the ECC engine and the plurality of data pads.

11. The memory device of claim 1, wherein each of the plurality of cell groups includes:
first word lines configured to share first sub-word line drivers among the sub-word line drivers with an adjacent cell group in a first direction; and
second word lines arranged alternately with the first word lines in a second direction intersecting the first direction, and configured to share second sub-word line drivers among the sub-word line drivers with an adjacent cell group in an opposite direction of the first direction.

12. A memory system comprising:
at least one memory device; and
a memory controller configured to control operations of the at least one memory device,
wherein the at least one memory device comprises:
a memory cell array including a plurality of cell groups, each cell group including adjacent ones of a plurality of cell blocks and alternately sharing sub-word line drivers with adjacent cell groups;
a mapping control circuit configured to generate a mapping control signal according to an output option signal, while selectively inverting at least one bit of the mapping control signal based on a row address and a repair control signal including information on a repaired cell group among the plurality of cell groups; and
a mapping circuit configured to select one of two adjacent cell groups based on respective bits of the mapping control signal, and to map selected cell groups to a plurality of data pads.

13. The memory system of claim 12, wherein each of the at least one memory device and the memory controller includes an error correction code (ECC) engine.

14. The memory system of claim 12,
wherein the plurality of cell blocks includes first to 4n-th normal cell blocks, a redundancy cell block, and an ECC cell block, which are arranged in a first direction, n being an integer equal to or greater than 1, and
wherein adjacent ones of the first to 4n-th normal cell blocks are grouped to form first to 2n-th normal cell groups, and the redundancy cell block and the ECC cell block are grouped to form an extra cell group.

15. The memory system of claim 14, wherein the mapping control circuit is configured to:
identify n normal cell groups among the first to 2n-th normal cell groups according to the output option signal; and
detect that the repaired cell group is included in the n normal cell groups and that one of the n normal cell groups shares the sub-word line drivers with the extra cell group based on the repair control signal and the row address to invert a bit of the mapping control signal, corresponding to the repaired cell group.
